# EUROPEAN PATENT APPLICATION

(11) **EP 1 648 058 A1**
(43) Date of publication of application: **19.04.2006**
(21) Application number: 04405650.5
(22) Date of filing: 18.10.2004
(51) Int. Cl.: H01S 5/06, H01S 5/50, G02F 1/35, H01S 5/026

(54) **An integrated holding-beam-at-transparency (HBAT) configuration for semiconductor optical amplification or emission**

(71) Applicant: ECOLE POLYTECHNIQUE FEDERALE DE LAUSANNE (EPFL), 1015 Lausanne (CH)
(72) Inventor: Dupertuis, Marc, 1322 Croy (CH); Crottini, Andrea, 1004 Lausanne (CH); Salleras Vila, Ferran, 1004 Lausanne (CH); Deveaud-Pledran, Benoit, 1006 Lausanne (CH)
(74) Representative: Cronin, Brian Harold John

(57) **Abstract**

An optical device for amplifying or emitting an optical beam of given wavelength comprises an in-line transparent source (20) in combination with a primary optical device (10) which is a semiconductor optical amplifier (SOA), a gain-clamped semiconductor optical amplifier (GCSOA), a sub-threshold gain-clamped semiconductor optical amplifier (SGCSOA), a laser diode (LD) or a superluminescent LED (SLED). The primary optical device (10) (SOA,GCSOA,SGCSOA,LD or SLED) delivers an output signal of given wavelength called the signal beam and optionally receives an input beam at the same wavelength as the signal beam. Operation of the primary optical device (10) (SOA,GCSOA,SGCSOA,LD or SLED) is assisted by a holding beam supplied by the optical source to the primary optical device (10). The holding beam is of smaller wavelength than the signal beam, the holding beam wavelength being tuned close to the transparency wavelength of the primary optical device to provide a holding beam at transparency (HBAT) mode. The ITS (20) and the SOA, GCSOA, SGCSOA or LD (10) are integrated in a single semiconductor chip in an in-line configuration. The ITS (20) is transparent at the signal wavelength in the SOA, GCSOA, SGCSOA, LD or SLED (10). The inventive integrated HBAT configurations allow extremely fast, high-gain and low noise operation of the SOA's, GCSOA's or SGCSOA's. They are well-suited for high-power, low noise and high speed WDM applications. The inventive integrated HBAT scheme for LD's provides laser sources with damped relaxation oscillations. Such devices, under fast direct modulation, are suitable sources for the access and metro telecommunication network.

## Description

### Field of the Invention

The invention relates to an optical device (in particular an optical amplifier) for amplifying or emitting an optical beam of given wavelength, comprising an in-line transparent source (ITS) in combination with a semiconductor optical amplifier (SOA), a gain-clamped semiconductor optical amplifier (GCSOA), a sub-threshold gain-clamped semiconductor optical amplifier (SGCSOA), a laser diode (LD) or a superluminescent LED (SLED), operated in a mode called "holding beam at transparency" (HBAT) which encompasses the so-called optical speed-up at transparency mode (OSAT) known from the literature.

### Background of the Invention

To improve the speed and linearity of standard semiconductor optical amplifiers a novel scheme called OSAT was designed. See the publication «Extremely fast, high-gain and low-current semiconductor optical amplifier by optical speed-up at transparency», M.-A. Dupertuis, J.L. Pleumeekers, T.P. Hessler, P.E. Selbmann, B.Deveaud, B.Dagens, J.Y. Emery, Photonics Technology Letters 12(11), pp. 1453-1455 (2000). It was first theoretically proven that the OSAT has specific advantages, on the one hand over the GCSOA as proposed in «Travelling wave semiconductor optical amplifier with reduced nonlinear distortions», J.C.Simon, P.Doussière, P.Lamouler, I.Valiente, F.Riou, Electron. Lett. 30, pp.49-50 (1994) which adds a short wavelength laser resonator around the SOA, and on the other hand also over a three wavelength device (TWD) as described in «Three-wavelength device for all-optical signal processing», RJ.Manning, D.A.O.Davies, Opt. Lett. 19(12), pp.889-891 (1994). With respect to the TWD the OSAT produces a larger gain or has much lower injection current. OSAT is the only ultrafast SOA set-up which allows very high optical gain (e.g. 30 dB).

The specific difference of the OSAT with respect to the GCSOA is that the OSAT optical beam is external to the SOA, which gives rise to higher possible gain and higher speed at a much lower injection current whilst avoiding relaxation oscillations and dark holes. It does not mean that the external laser source cannot be integrated on the same chip as the SOA although so far this has not been implemented.

Recently the OSAT scheme has been generalized to the transparency point of LD's as well. It has been shown theoretically that the response of typical fast lasers, for use under direct modulation at 2.5 Gbps in access and metro telecommunication networks, could be improved (reduced power fluctuations and less chirp). The present invention will also include such sources, as well as closely related superluminescent light emitting diodes (SLED's).

First, we recall the principle of the OSAT.

### Principle of optical speed-up at transparency (OSAT):

In a GCSOA, the response speed is determined by the relaxation oscillation damping which increases linearly with the injection current. The current density exceeding threshold is used for laser emission which induces high linearity and faster operation.

In the TWD configuration, the reduced/enhanced amplification of the holding beam is replacing the role of the laser mode of the GCSOA. The device spoils a large amount of current to amplify the saturating holding beam at the operating point. However with respect to SOA and GCSOA it offers the advantages of a faster response as well as an absence of detrimental relaxation oscillation and back modulation by the lasing mode.

To decrease the recovery time, an SOA set-up was proposed, called OSAT (Optical Speed-up At Transparency), where a light beam is continuously injected around the transparency point wavelength of the active semiconductor medium. The effect of this light beam is neutral at steady-state: neither the required injection current, nor the SOA small-signal gain will be affected (whatever the intensity of the neutral beam). On the other hand, as soon as the SOA carrier density will be perturbed by an incoming signal, the neutral injected beam will be absorbed or amplified, and the SOA will recover much faster its operating point carrier density. Very recently it has also been shown that the OSAT scheme could largely improve also the response of fast directly modulated LD's.

The OSAT scheme has numerous advantages for SOAs and LD's (speed, high gain, linearity, saturation power, cascadability, no relaxation oscillations, chirp etc...), but requires a high-power external-laser beam at transparency. The required power is usually at least 30mW, and preferably above 100mW. The disadvantages of known OSAT configurations are that the high-power source may require a significant additional current, which may be prohibitive for practical applications, and in addition to the cost of the high-power source, expensive optical interconnections e.g. optical couplers, isolators, etc... may be required.

A more general new denomination HBAT ("Holding Beam At Transparency") has been chosen instead of OSAT ("Optical Speed-up At Transparency") because it has been observed that a holding beam at transparency may be used for different purposes than just to speed-up the device: for example it is possible to obtain devices with improved noise figure or higher saturation powers. The HBAT scheme comprises the OSAT scheme.

### Summary of the Invention

An object of the invention is to provide integrated and flexible solutions that simplify the integrated OSAT or HBAT scheme and simultaneously reduce the coupling losses, the noise, the current requirements and the cost of the known OSAT configuration. Such solutions are applicable both to SOA's, GCSOA's, SGCSOA's, LD's or SLED's.

According to the invention, there is provided an optical device for amplifying or emitting an optical beam of given wavelength, comprising a primary optical device that amplifies or emits an optical beam of given wavelength, in combination with a transparent optical source that assists the primary optical device. The primary optical device is for example selected from a semiconductor optical amplifier (SOA), a gain-clamped semiconductor optical amplifier (GCSOA), a sub-threshold gain-clamped semiconductor optical amplifier (SGCSOA), a laser diode (LD) and a superluminescent LED (SLED). A SGCSOA is a device whose structure is similar to a GCSOA, except that it is operated under the lasing threshold.

The primary optical device (SOA, GCSOA, SGCSOA, LD or SLED) delivers an output signal of given wavelength called the signal beam and optionally (in the case of an SOA, GCSOA or SGCSOA) receives an input beam at the same wavelength as the signal beam. This primary optical device determines the functionality of the optical device according to the invention, i.e. as a semiconductor optical amplifier in the case the primary optical device is an SOA, etc.

Operation of the primary optical device (SOA, GCSOA, SGCSOA, LD or SLED) is assisted by a holding beam (or "assist beam") supplied by the optical source to the primary optical device. The holding beam is of smaller wavelength than the signal beam, and the holding beam wavelength is tuned close (a few nm) to the transparency wavelength region of the primary optical device to provide a holding beam at transparency (HBAT).

The transparency wavelength region of the primary optical device is rigorously defined by the spectral region between the average active material transparency point of the primary optical device and the overall modal transparency point of the primary optical device. Its spectral width is usually ~10 nm.

According to the invention, the optical source is an in-line transparent source (ITS); the optical source (ITS) and the primary optical device (SOA, GCSOA, SGCSOA, LD or SLED) are integrated in a single semiconductor chip; the optical source (ITS) and the primary optical device (SOA, GCSOA, SGCSOA, LD or SLED) are disposed in a configuration in which all optical beams that they receive, emit and/or amplify are in-line; and the optical source (ITS) is transparent at the signal beam wavelength in the primary optical device (SOA, GCSOA, SGCSOA, LD or SLED).

This configuration achieves substantial power savings in terms of current by integrating the power source for the holding beam at transparency with an in-line design. It also reduces the coupling losses (for both signal and the internal HBAT beam) and the optical noise at signal wavelengths compared to a straightforward integrated version of the standard Y-coupling scheme.

The invention thus provides HBAT integrated configurations (on a single chip) with semiconductor optical amplifiers (SOA's), or gain-clamped semiconductor optical amplifiers (GCSOA's), or sub-threshold gain-clamped semiconductor optical amplifiers (SGCSOA's), or laser diodes (LD's), or superluminescent light emitting diodes (SLED's). These configurations include one or two high power sources (ITS's) and one or two SOA's or LD's disposed in inline configurations. For SOA's the devices provide speed, high saturation power, low overall current consumption, and low noise. The inventive integrated OSAT configurations allow extremely fast, high-gain operation of the SOA's. They are particularly well-suited for high-power, low noise and high speed WDM (wavelength-division multiplexing) applications. The inventive integrated OSAT scheme for LD's provides laser sources with damped relaxation oscillations. Such devices, under fast direct modulation, are suitable sources for the access and metro telecommunication network.

The inventive integrated HBAT configurations has the following advantages:
- The device is a simple and flexible in-line configuration.
- The device requires only existing growth and processing technology for SOA and GCSOA (DFB or DBR mirrors, standard lateral structures, one regrowth), and can be produced at a much lower cost than non-integrated HBAT/OSAT configurations, or integrated HBAT/OSAT configurations which represent straightforward integrated versions of the standard Y-coupling scheme for the source of the HBAT/OSAT holding beam.
- The in-line configuration has the definite advantage to provide reduced coupling losses (for both the signal and the holding beam). At least 3dB of power is saved by avoiding a Y-coupler, and no additional bending losses (typically 1dB) are expected.
- The device will have an improved noise figure (lower noise) or higher saturation powers.
- The device proposed is optically accessible at both ends like a normal SOA, can be turned both ways, and uses the same mounting and packaging as a GCSOA.
- Fine-tuning can be done by adjusting the current in the different regions (SOA and ITS regions).
- The device represents a solution that also recycles all the spoiled ASE from both sides of the ITS. This recycling will allow to save some current in the SOA (or GCSOA, or SGCSOA, or LD, or SLED) regions.
- For laser diodes (LDs), the device provides laser sources with damped oscillations.

Further features and advantages of the device according to the invention are set out in the following description and in the claims.

### Brief Description of the Drawings

In the accompanying drawings, given by way of example:
Fig. 1 is a graph of a gain curve of an SOA and a gain curve of a suitable in-line transparent high-power source (ITS) as a function of wavelength λ;
Fig. 2 is a schematic diagram of a first in-line configuration (ILS) according to the invention;
Fig. 3 is a schematic diagram of a second in-line configuration (SILS-1) according to the invention;
Fig. 4 is a schematic diagram of a third in-line configuration (SILS-2) according to the invention;
Fig. 5 is a schematic diagram of a fourth in-line configuration (SILS-3) according to the invention;
Fig. 6 is a schematic diagram of a fifth in-line configuration (SILS-4) according to the invention; and
Fig. 7 is a schematic cut-away perspective view of an integrated optical amplifier according to the invention, further showing schematic cross-sections of the passive waveguides, the ITS-HBAT active region and SOA active region.

### Detailed Description

A suitable in-line transparent high-power source according to the invention (ITS) should meet the following requirements :
- The ITS source must supply an intense optical beam at wavelength λ₂ usually at least 50 mW in SOA, preferably more than 100 mW.
- The wavelength λ₂ of the optical beam emitted by the ITS source must be at the transparency point of the SOA (or GCSOA or SGCSOA or LD or SLED)
- The ITS source must not generate noise at the signal wavelength λ₁ in SOA.
- The ITS source must be transparent at the signal wavelength λ₁.

The first two requirements are the HBAT requirements, the last two requirements allow the source to be used in-line with the SOA's.

In the case where the primary optical device is a sub-threshold GCSOA (SGCSOA) the optical cavity of the SGCSOA is tuned at the frequency of the HBAT.

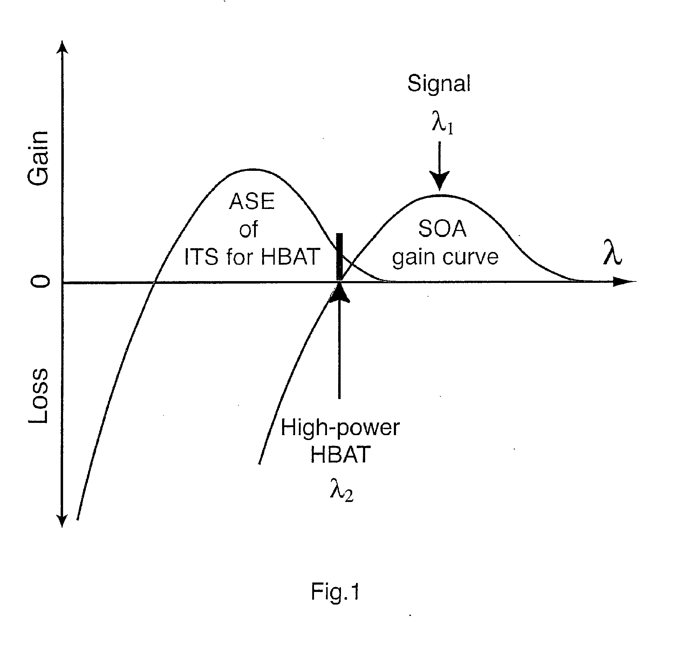

Fig. 1 displays the gain curve of an SOA and the gain curve of a suitable integrable high-power optical source which meets all the previous requirements. In the device according to the invention, the HBAT source is operated either at its gain maximum or on the low energy (long wavelength) side of its gain curve like in Fig. 1, but in either cases the band edge of the HBAT source is designed to be at smaller wavelength than the signal wavelength region in the primary optical device. This allows the high-power HBAT source to be transparent at the signal wavelength λ₁, without noise (the last two requirements). A significant advantage of such a gain configuration is that the amplified spontaneous emission ASE of the high-power ITS will be simultaneously absorbed in the SOA. This leads to significant current saving as the unavoidable ASE of the high-power source is not lost but recycled as an auxiliary pump mechanism for the SOA. Such a source is the so-called ITS source, used in this invention, operating to provide a HBAT mode.

The optional mirrors of the integrable high-power source must be highly transparent for all signal wavelengths, as well as for the self-generated ASE. Preferred embodiments make use of a DFB (distributed feedback) cavity or DBR (distributed Bragg reflector) mirrors. This includes also derived DFB schemes like λ/4 shifted DFB resonators and 2 x λ/8 shifted DFB resonators. In order to avoid reflectivity/transmission ripples outside the stop-band, optionally apodized gratings are used to suppress the ripples. The device further comprises an optical waveguide, in particular an adiabatic optical waveguide, between the in-line transparent optical source (ITS) and the primary optical device (SOA, GCSOA, SGCSOA, LD or SLED).

The lateral structure of the integrable high-power source can be of any suitable type (ridge or buried). Particular attention will be paid to a compatible choice with respect to the SOA integrated on the same chip.

The ASE at wavelength slightly above the transparency point may be of concern, since it may slightly couple the ITS source and the SOAs, however optimum detuning around the transparency point can be determined by experimentation. Otherwise generally speaking the ITS source will not be sensitive to feedback from the SOAs. Moreover, a high quality single-mode HBAT laser beam is not required, (apart from its stationarity). Optionally a high power superluminescent light emitting semiconductor diode (SLED) could also be considered as an ITS provided the emitted incoherent optical beam is sufficiently intense and spectrally narrow. This allows more freedom in the ITS design. Alternatively a laser diode (LD) could be used as a source. In all cases the ITS source should not generate noise at the signal beam wavelength.

### The sandwiched in-line source (SILS) configuration

The present invention aims to provide an extremely efficient solution to the problem of integrating the high-power HBAT source with the primary optical device such as the SOA itself. This is achieved by an in-line configuration that avoids the loss of power inherent with a standard Y configuration.

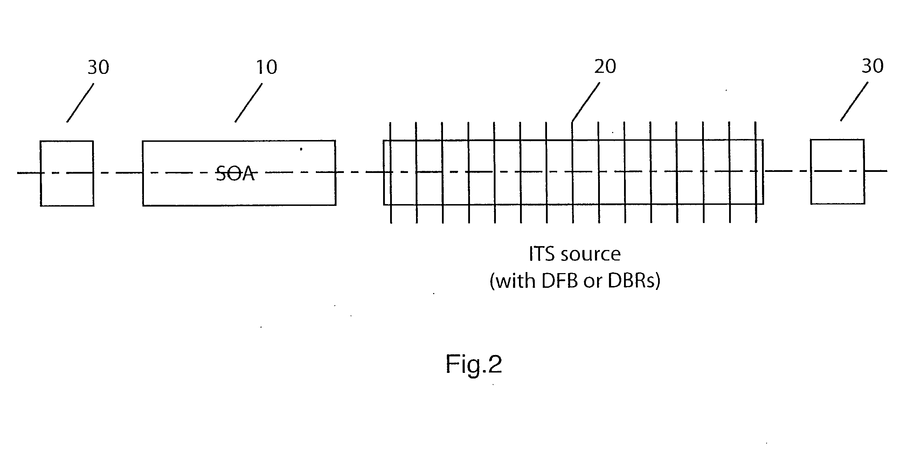

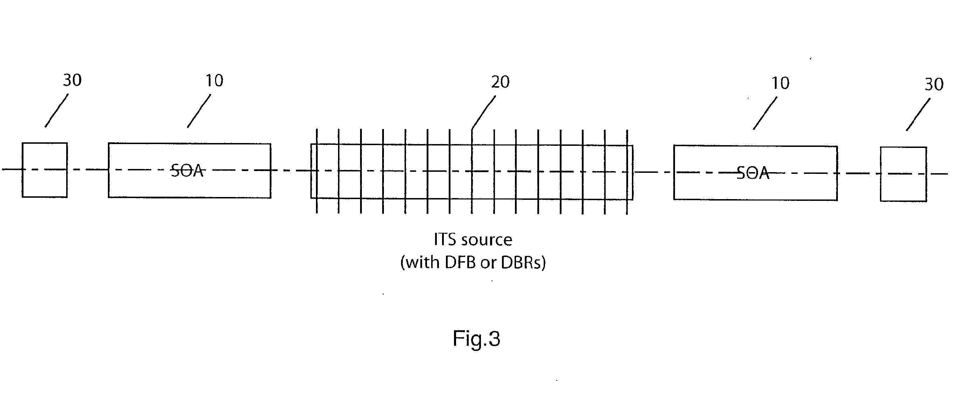

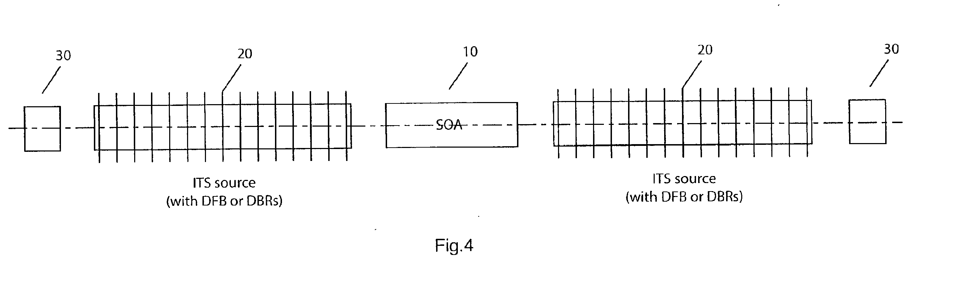

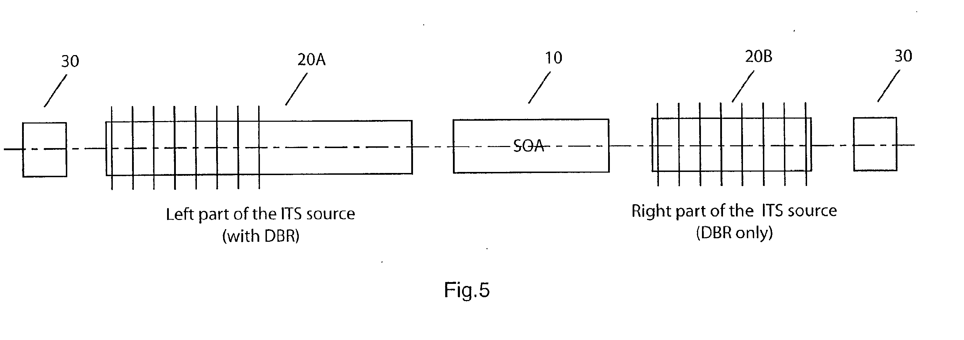

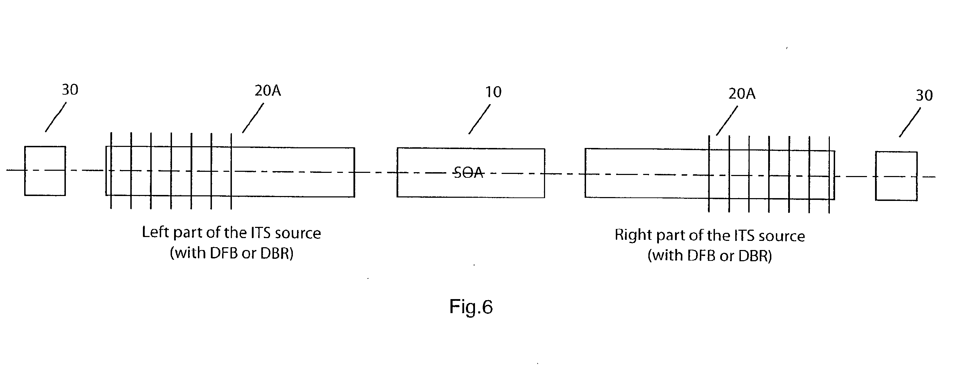

Five basic in-line configurations which involve one or two HBAT sources and one or two SOAs (or GCSOA's, or SGCSOA's, or LD's, or SLED's) are possible:
1) In-line high-power source (ILS configuration), one ITS source arranged in-line and adiabatically coupled to one primary optical device - Fig. 2.
2) Sandwiched in-line high-power source (SILS-1 configuration), one ITS source arranged in-line between two primary optical devices, SOA - ITS - SOA - Fig. 3.
3) Sandwiched in-line primary device configuration (SILS-2 configuration), one primary optical device arranged in-line between two ITS sources, - ITS - SOA - ITS Fig. 4.
4) Sandwiched in-line SOA asymmetric configuration, a primary optical source arranged in-line between two parts of the ITS source, - Fig. 5 (SILS-3 configuration).
5) Sandwiched in-line SOA symmetric configuration, a primary optical source arranged in-line between two symmetric parts of the ITS source - Fig. 6 (SILS-4 configuration).

In these five figures the part of the device named SOA (semiconductor optical amplifier) represents an SOA as primary optical device which could be replaced by a GCSOA, or a SGCSOA, or a LD, or a SLED, depending on the application.

The device is a simple in-line configuration. The device is optically accessible at both ends like a normal SOA, and has the same mounting and packaging as a GCSOA. Fine-tuning can be done by adjusting the current in the two or three regions (ITS sources and SOA's)

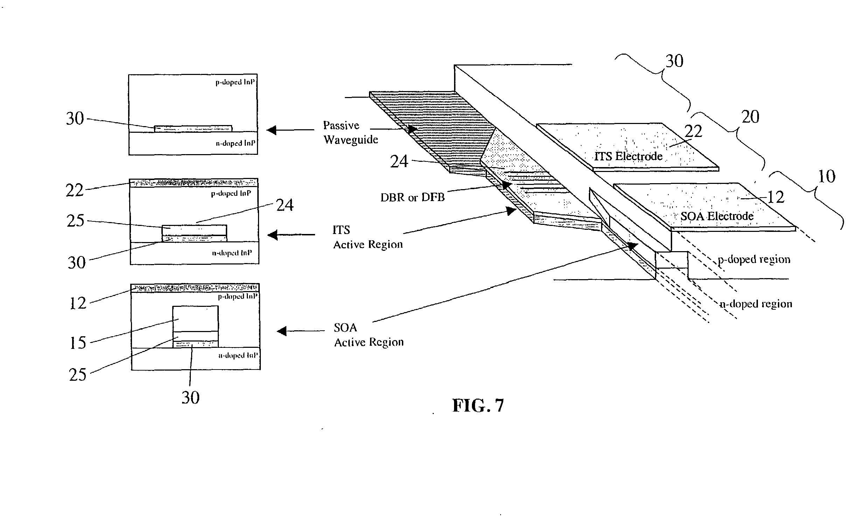

As illustrated in Fig. 7, the integrated in-line configurations require only existing growth and processing technology for SOA, GCSOA and SGCSOA (DFB or DBR mirrors, standard lateral structures, one regrowth).

In Fig. 2, a SOA 10 forming the primary optical device is integrated in a single chip with an ITS 20 having a DFB or DBR. These two elements are aligned in-line via an intermediate waveguide 30 for the holding and signal beams. This in-line configuration, called the ILS configuration, is signal co- or counter-propagating.

In Fig. 2, as also in Figs. 3-6, the waveguide 30 is illustrated as extending in-line from one end of the device to the other (the width of the waveguide 30 varying along the length of the device, as explained later in conjunction with Fig. 7). The waveguide 30 serves for the input of incoming beams, the output of signal beams generated or amplified in the device, and the transmission of the holding and signal beams inside the device. All optical beams received, emitted and/or amplified by the device are in-line

This in-line configuration differs from the straightforward integrated version of standard Y-coupler configuration where the holding beam is led into a wavelength selective Y-coupler by a waveguide for the HBAT beam, and the Y-coupler has an axial waveguide for the SOA signal.

In Fig. 3, two SOA's 10 as primary optical devices are integrated in a single chip with an ITS 20 having a DFB or DBR. These three elements are aligned in-line via intermediate waveguides 30 for the holding and signal beams, with the ITS 20 sandwiched between the two SOA's 10. This in-line configuration, called the SILS-1 configuration, is also signal co- or counter-propagating.

In Fig. 4, one SOA 10 as principal optical device is integrated in a single chip with two ITS's 20 each having optionally a DFB or two DBR mirrors forming an optical cavity. These three elements are aligned in-line via intermediate waveguides 30 for the holding and signal beams, with the SOA 10 sandwiched between the two ITS's 20. This in-line configuration, called the SILS-2 configuration, is also signal co- or counter-propagating. The two ITS 20 may optionally provide optical holding beams at slightly different wavelengths within the transparency region.

In Fig. 5, one SOA 10 as principal optical device is integrated in a single chip with one ITS split into two asymmetric parts 20A and 20B each having a DFB or DBR. The two parts of the ITS are not symmetric with respect to each other, for example the left hand part 20A contains the principal parts of the ITS including a DBR mirror, whereas the right hand part 20B contains only a DBR mirror of the ITS source. These three elements are aligned in-line, with the SOA 10 sandwiched between the two parts 20A and 20B of the ITS. This in-line configuration, called the SILS-3 configuration, is also signal co- or counter-propagating. Just as for the previously-described symmetric devices, either side of this asymmetric device can form the input, and the remaining side will always be the output.

In Fig. 6, one SOA 10 as principal optical device is integrated in a single chip with one ITS split into two symmetric parts 20A each comprising a DFB or DBR forming the end of the optical cavity of the ITS. The two parts 20A of the ITS are symmetric with respect to each other. These three elements are aligned in-line, with the SOA 10 sandwiched between the two parts of the ITS 20. This in-line configuration, called the SILS-4 configuration, is also signal co- or counter-propagating.

Fig. 7 schematically illustrates in cut-away perspective view the structure of the chip incorporating the in-line ITS - SOA configuration of Fig. 4 (the front ITS is cut away, and the cut-away front part is symmetrical with the illustrated rear part; the device is also symmetrical about its longitudinal cut). The part of ITS shown by way of example in the figure includes three subsections: a passive waveguide 30, an ITS 20 and a SOA 10. The subsections (shown in cross-section on the left of figure) comprise stacked layers made of ternary or quaternary alloys, embedded in Indium Phosphide, for example, p-doped at the top and n-doped at the bottom (in the orientation of Fig. 7). Ternary or quaternary alloys are used in a manner that is known to constitute guides for optical beams. The passive waveguide region 30 is characterized by a low refractive index layer (for example n=3.2, for 1200 nm wavelength InGaAsP alloys), the ITS active region 25 by a medium refractive index (e.g. n=3.45, for λ₂= 1480 nm transparency wavelength in InGaAsP alloys), the SOA active region 15 by a high refractive index (e.g. n=3.5 for λ₁=1550 nm). The differences in the refractive indexes allow for an adiabatic transfer of optical modes between regions, for better optical coupling. Optical coupling is improved by progressive lateral decrease in the width of the upper layer 15 (which is tapered at its ends) accompanied by a progressive lateral increase in the width of the bottom layer 30 forming the passive waveguide. Passive waveguide regions 30 are made of transition elements to enable low-loss coupling to external components such as an optical fibers, air, another ITS-OSAT region (the presented part of ITS can be put in cascade). The ITS electrodes 22 and SOA electrodes 12 are formed on the bottom face of ITS and SOA sub-sections 20,10 (shown upside down in Fig. 7) to independently enable injection of electrical currents in active regions between p-doped and n-doped layers. The ITS active region 25 is provided on its face facing the electrode 22 with DFB or DBR mirrors 24.

The described device is in-line with respect to the waveguide 30 of the signal beam (input or output) which extends all the way along the device. The device is transparent with respect to the wavelength of the signal beam produced by SOA 10.

The described semiconductor chip with the integrated device according to the invention can be made by usual chip-processing techniques. The same type of construction can be adapted to the similar embodiments of Figs. 2-3 and 5-6. The functionality of the overall device is defined by the functionality of the primary optical device which in Fig. 7 is the SOA 10. In operation, the SOA 10 receives an input beam, from an external source via the waveguide 30, and produces an amplified output beam called the signal beam which is an amplified signal of given wavelength. Operation of the SOA is assisted by a holding beam supplied by the ITS 20. This holding beam provides a high power of preferably more that 100 mW. The holding beam supplied by ITS 20 has a smaller wavelength than the signal beam of SOA 10 and this holding beam wavelength is tuned close to the transparency wavelength of the SOA, providing a holding beam at transparency called the HBAT mode. In the given example, the wavelength of the SOA's signal beam λ₁ can be 1550 nm and the wavelength of the holding beam λ₂ can be 1480 nm, the latter depending on the pump current in the SOA. The wavelength of the holding beam can be tuned by about 10 nm.

One or more optical devices according to the invention can be integrated in a single semiconductor chip as a sub-component of a more complex optical device, such as a Mach-Zehnder interferometer switch, for example of the type described in "All-Optical Switching at Multi-100-Gb/s Data Rates with Mach-Zehnder Interferometer Switches". Roland P. Schreieck et al. IEEE Journal of Quantum Electronics, Vol. 38, No. 8, August 2002. Taking the Mach-Zehnder interferometer switch shown in Fig, 7 of that paper as example, it would suffice to replace each SOA with a device according to the invention having an SOA as its principal optical element, all integrated in the same semiconductor chip. In principle, a SOA, GCSOA, SGCSOA, LD or SLED incorporated in any complex optical device can be replaced with a device according to the invention with the appropriate element as its principal optical device.

Devices according to the invention can function in many wavelength regions. For example for short distance or computer applications the 800 nm or 980 nm wavelength region can be of special interest, for telecommunication applications the 1300 nm and 1550 nm regions are specific windows for dispersionless or long-distance optical fibers.

## Claims

1. An optical device for amplifying or emitting an optical beam of given wavelength, comprising a primary optical device (10) that amplifies or emits the optical beam of given wavelength, in combination with a transparent optical source (20) that assists the primary optical device, wherein :
- the primary optical device (10) delivers an output signal of given wavelength called the signal beam and optionally receives an input beam at the same wavelength as the signal beam;
- operation of the primary optical device (10) is assisted by a holding beam supplied by the optical source (20) to the primary optical device (10), the holding beam being of smaller wavelength than the signal beam, the holding beam wavelength being tuned close to the transparency wavelength of the primary optical device to provide a holding beam at transparency (HBAT) mode;
- the optical source (20) is an in-line transparent source (ITS);
- the optical source (20) and the primary optical device (10) are integrated in a single semiconductor chip;
- the optical source (20) and the primary optical device (10) are disposed in a configuration in which all optical beams that they receive, emit and/or amplify are in-line; and
- the optical source (20) is transparent at the signal beam wavelength from the primary optical device (10).

2. The optical device of claim 1, wherein the primary optical device (10) is selected from a semiconductor optical amplifier (SOA), a gain-clamped semiconductor optical amplifier (GCSOA), a sub-threshold gain-clamped semiconductor optical amplifier (SGCSOA), a laser diode (LD) and a superluminescent light-emitting diode (SLED).

3. The optical device of claim 1 or 2, wherein the in-line transparent optical source (20) supplies a holding beam with a power of at least 50 mW, preferably more than 100 mW.

4. The optical device of claim 1, 2 or 3, wherein the in-line transparent optical source (20) is a laser diode (LD), or a superluminescent light-emitting diode (SLED) that does not generate noise at the signal beam wavelength.

5. The optical device of any preceding claim, wherein the in-line transparent optical source (20) comprises a distributed feedback (DFB) cavity or distributed Bragg reflectors (DBR).

6. The optical device of any preceding claim, comprising an optical waveguide (30), in particular an adiabatic optical waveguide, between the in-line transparent optical source (20) and the primary optical device (10).

7. The optical device of any preceding claim, comprising one in-line transparent optical source (20) arranged in-line and adiabatically coupled to one primary optical device (10).

8. The optical device of any one of claims 1 to 6, comprising one in-line transparent optical source (20) arranged in-line between two the primary optical devices (10).

9. The optical device of any one of claims 1 to 6, comprising one primary optical device (10) arranged in-line between two in-line transparent optical sources (20).

10. The optical device of claim 9, wherein two in-line transparent optical sources (20) are set or settable to provide holding beams at different wavelengths close to or in the transparency wavelength region of the primary optical device.

11. The optical device of any one of claims 1 to 5, where the in-line transparent optical source (20) is split into two in-line parts (20A,20B), and the primary optical device (10) is inserted in-line between said two parts of the in-line transparent optical source (20) that are symmetric (20A/10/20A) or asymmetric (20A/10/20B) about the primary optical device.

12. The optical device of claim 11, comprising an optical waveguide (30), in particular an adiabatic optical waveguide, between the primary optical device (10) and said parts (20A/20A;20A/20B) of the in-line transparent optical source (20).

13. The optical device of any preceding claim integrated in a semiconductor chip incorporating an active region (15) of the primary optical device (10) and an active region (25) of the transparent optical source(s) (20), said active regions (15,25) being disposed on a waveguide (30) that extends in-line through the entire device, wherein:
- the active region (15) of the primary optical device(s) (10) has a smaller cross-sectional width and a greater cross-sectional height relative to the corresponding dimensions of the active region (25) of the transparent optical source (20); and
- the active region (25) of the transparent optical source(s) (20) has a greater cross-sectional width a smaller cross-sectional height relative to the corresponding dimensions of the active region (15) of the primary optical device (10).

14. The optical device of any preceding claim integrated in a single semiconductor chip as a sub-component of a more complex optical device.

15. The optical device any one of claims 1 to 13 integrated in a Mach-Zehnder interferometer.
